# EUROPÄISCHE PATENTSCHRIFT

(11) **EP 1 924 947 B1**
(45) Veröffentlichungstag und Bekanntmachung des Hinweises auf die Patenterteilung: **12.01.2011**
(21) Anmeldenummer: 06805703.3
(22) Anmeldetag: 13.09.2006
(51) Int. Cl.: G06K 7/00, H01L 23/58

(54) **MANIPULATIONS- UND DURCHBOHRSCHUTZ FÜR EINE AN EINE ELEKTRISCHE SCHALTUNG ANZUSCHLIESSENDE VORRICHTUNG**
PROTECTION AGAINST MANIPULATION AND THROUGH-DRILLING FOR AN APPARATUS TO BE CONNECTED TO AN ELECTRICAL CIRCUIT
PROTECTION CONTRE LES MANIPULATIONS ET LES PERFORATIONS POUR UN DISPOSITIF A RELIER AVEC UN CIRCUIT ELECTRIQUE

(30) Priorität: 13.09.2005 DE 102005043640; 14.11.2005 DE 102005054211; 21.08.2006 DE 102006039136
(43) Veröffentlichungstag der Anmeldung: 28.05.2008
(73) Patentinhaber: Amphenol-Tuchel Electronics GmbH, 74080 Heilbronn (DE)
(72) Erfinder: KERNER, Manfred, 74235 Erlenbach (DE); MAITERTH, Eduard, 74074 Heilbronn (DE)
(74) Vertreter: Wagner, Karl H.
(86) Internationale Anmeldenummer: PCT/EP2006/008922
(87) Internationale Veröffentlichungsnummer: WO 2007/031299

(56) Entgegenhaltungen:
- EP-A1- 0 526 066
- DE-A1- 19 600 769
- GB-A- 2 411 756

## Beschreibung

Die Erfindung bezieht sich auf einen Manipulations- und Durchbohrschutz insbesondere für eine an eine elektrische Schaltung anzuschließende Vorrichtung, wie beispielsweise für einen Smart Card Reader, auch Smart Card Connector genannt, oder eine Magnetkartenleseeinrichtung.

Smart Card Reader werden auf vielen Gebieten der Technik eingesetzt, um die in der Smart Card enthaltene Information einzulesen, auszulesen und zu ändern.

In der Druckschrift GB-A-2 411 756, wird ein Kartenleser mit mehreren Sicherheitsmitteln beschrieben. Der Zugang zum Hauptkreis des Lesers ist durch ein Gehäuse unterbunden, dessen Wände mit Kontaktbahnen durchzogen sind. Das Durchbrechen oder Erden dieser Kontaktbahnen kann elektronisch detektiert werden.

Das Dokument DE 196 00 769 A1 zeigt ein Sicherheitsmodul mit einem Gehäuse zur Aufnahme von elektronischen Geräten, Daten und anderen sensiblen Informationen. Das Modul ist umhüllt von einer flexiblen Folie aus leitendem Material oder einer Folie mit mäanderförmigen Leiterbahnen.

In einem weiteren Dokument mit der Bezeichnung EP-A1-0 526 066 ist ein Sicherheitsgehäuse offenbart, welches eine flexible, elektrisch isolierende Lage aufweist, die das gesamte Gehäuse umfasst. Diese Lage enthält elektrisch leitende Bahnen auf beiden Seiten der Lage. Das Gehäuse weist weiterhin einen Stromkreis zum Detektieren einer Änderung der elektrischen Eigenschaften der Leiter auf.

In der Praxis kommt es vor, dass unberechtigte Personen versuchen, aus verschiedenen Gründen den Smart Card Reader an- oder durchzubohren. Der Erfindung liegt die Aufgabe zugrunde, einen Smart Card Reader - aber auch allgemein ein elektrisches oder elektronisches Gerät - gegenüber Manipulationen insbesondere gegen An- bzw. Durchbohren zu schützen. Auch soll das Auftreten eines Manipulationsversuches ohne weiteres feststell- und registrierbar sein.

Erfindungsgemäß wird diese Aufgabe durch eine Vorrichtung nach Anspruch 1, sowie eine Vorrichtung gemäß Anspruch 10, gelöst. Weitere Ausgestaltungen der Erfindung ergeben sich aus den jeweiligen Unteransprüchen.

Die genannte Aufgabe wird erfindungsgemäß durch Anbringen eines Bohr- bzw. Manipulationsschutzgitters (kurz: eines Schutzgitters) gelöst. Das Schutzgitter besteht aus Leiterbahnen bzw. Leitern, durch die ein Strom ständig oder zeitweise geleitet werden kann. Das Schutzgitter kann direkt auf dem Smart Card Reader an einer oder mehreren geeigneten Stellen aufgebracht werden. Die das Schutzgitter bildenden Leiter bzw. Leiterbahnen sind über Kontakte bzw. Kontaktzonen aus dem Smart Card Reader herausgeführt, um Ströme oder Signale durch die elektrischen Leiter zu leiten.

Gemäß einem Ausführungsbeispiel der Erfindung wird der Manipulationsschutz nur für den, aus einem Smart Card Reader hervorragende Flexprint vorgesehen. Der Ausdruck "Flexprint" wird als Kurzform für eine flexible Lei-Kurzform für eine flexible Leiterflachplatte verwendet. Gemäß einem Ausführungsbeispiel der Erfindung wird dieser eigentliche oder übliche zum Anschluss des Smart Card Readers verwendete Flexprint erfindungsgemäß mehrlagig, vorzugsweise dreilagig, ausgebildet. Dieser erfindungsgemäße Flexprint wird im Folgenden auch als Manipulations-Detektionsflexprint oder kurz als Detektionsflexprint bezeichnet. Der übliche Flexprint wird in dem Detektionsflexprint beispielsweise als eine mittlere Lage verwendet und als Datentransferflexprint bezeichnet. Diese mittlere Lage dient beidseitig als ein Träger für jeweils ein Schutzgitter tragende Elemente (Schutzgitterelemente).

Vorzugsweise wird auf der Oberseite des zum Anschluss der Kontaktelemente des Smart Card Readers und auch zum Anschluss de Schutzgitterelemente verwendeten Anschlussflexprints ein, vorzugsweise ebenfalls als Flexprint ausgebildetes erstes Schutzgitterelement, als erste Schutzlage (erstes Schutzgitterflexprint) vorgesehen. Auf der Unterseite des Datentransferflexprints ist sodann ein zweites Schutzgitterelement vorzugsweise in der Form eines Schutzgitterflexprints als zweite Schutzlage angeordnet.

Die drei Lagen, die vorzugsweise fest miteinander verbunden sind, bilden den erfindungsgemäßen integralen manipulationsgeschützten Detektionsflexprint.

Vorzugsweise bildet der Datentransferflexprint mit den oben und unten vorgesehenen Schutzgitterflexprints einen integralen manipulationsgeschützten Flexprint.

Durch den Detektionsflexprint des ersten Ausführungsbeispiels wird kein Schutz des gesamten Smart Card Reader Systems, welches aus dem Smart Card Reader und einem Anschluss vorzugsweise in der Form eines Flexprints besteht, erreicht, sondern nur für den eigentlichen Flexprint. Wie oben bemerkt, könnte aber ein Schutzgitter auch direkt auf dem Smart Card Reader aufgebracht, beispielsweise aufgedruckt, sein.

Gemäß einem weiteren Ausführungsbeispiel wird sowohl ein Schutz für den Smart Card Reader, als auch für den zum Anschluss dienenden üblichen Flexprint, dadurch erreicht, dass man einen noch zu beschreibenden Hüllenflexprint vorsieht, der den Smart Card Reader manipulationssicher einhüllt und auch den üblichen Flexprint gegen Manipulation schützt. Bei diesem zweiten Ausführungsbeispiel kann also der übliche, dem Anschluss des Smart Card Readers dienende Flexprint weiterhin verwendet werden.

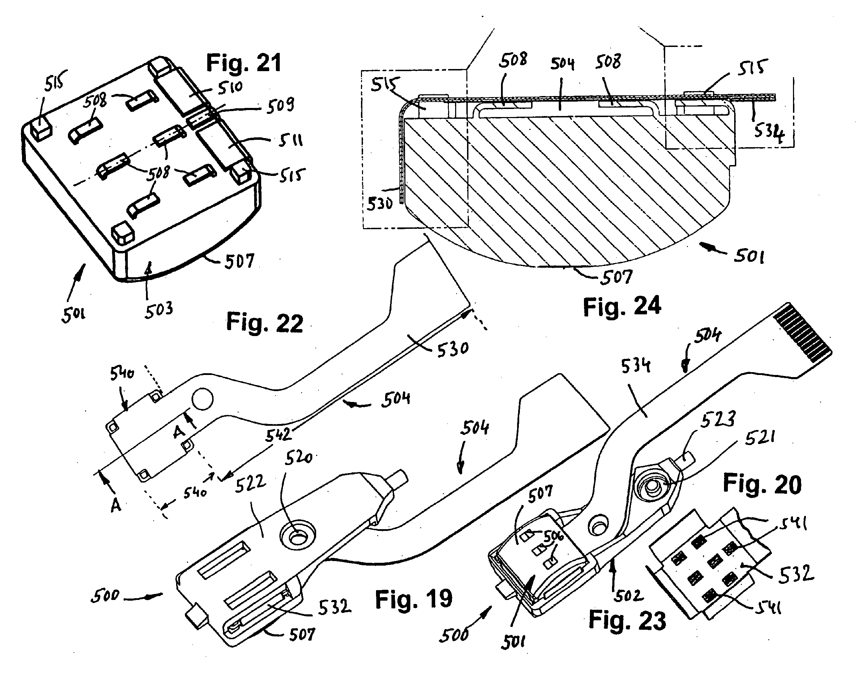

Häufig werden zusammen mit einem Smart Card Reader auch auf diesem angeordnete Magnetkartenleseeinrichtungen benutzt, die, ebenso wie ein Datentransferflexprint mit dem sie an ein elektrisches Gerät angeschlossen sind, auch einer Manipulation zum Opfer fallen können: Mit dem Problem der Manipulationssicherung einer Magnetkartenleseeinrichtung befasst sich ein weiteres, insbesondere in den Fig. 19 bis 27 beschriebenes Ausführungsbeispiel unter Verwendung der Prinzipien der ersten beiden Ausführungsbeispiele.

Weitere Vorteile, Ziele und Einzelheiten der Erfindung ergeben sich aus der Beschreibung eines Ausführungsbeispiels anhand der Zeichnung; in der Zeichnung zeigt
Fig.1 eine Seitenansicht eines erfindungsgemäßen, drei Lagen aufweisenden Flexprints;
Fig.2 eine Draufsicht auf die Oberseite des Datentransferflexprints;
Fig. 3 eine Draufsicht auf den ersten oder oberen Schutzgitterflexprint;
Fig. 4 eine Draufsicht auf eine untere Lage, d.h. den unteren Schutzgitterflexprint;
Fig. 5 schematisch eine erste Manipulationsart;
Fig. 6 schematisch einen zweite Manipulationsart;
Fig. 7 eine perspektivische Draufsicht auf die Oberseite eines bekannten Smart Card Readers mit einem üblichen zum Anschluss der Kontaktelemente des Smart Card Readers dienenden Datentransferflexprint.
Fig. 8 eine Unterseite des Smart Card Readers der Fig. 7 zusammen mit einem Hüllflexprint, der sich in einer Ausgangsposition vor dem Vornehmen der Umhüllung befindet;
Fig. 9 eine perspektivische Draufsicht auf die Unterseite, des durch den Hüllflexprint eingehüllten Smart Card Readers;
Fig. 10 eine Draufsicht auf die Oberseite des Smart Card Readers der

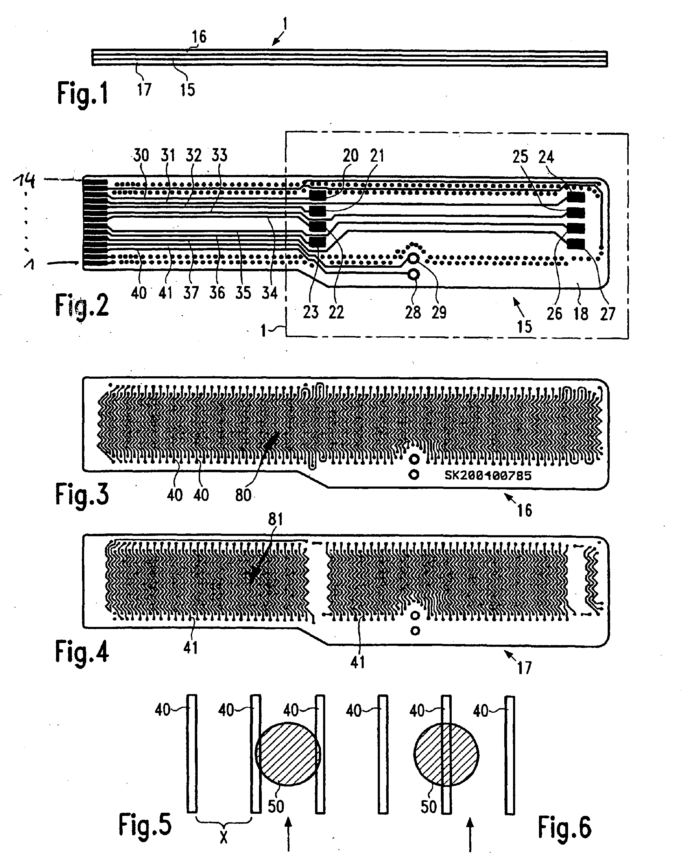

Fig. 1 in seinem eingehüllten Zustand;

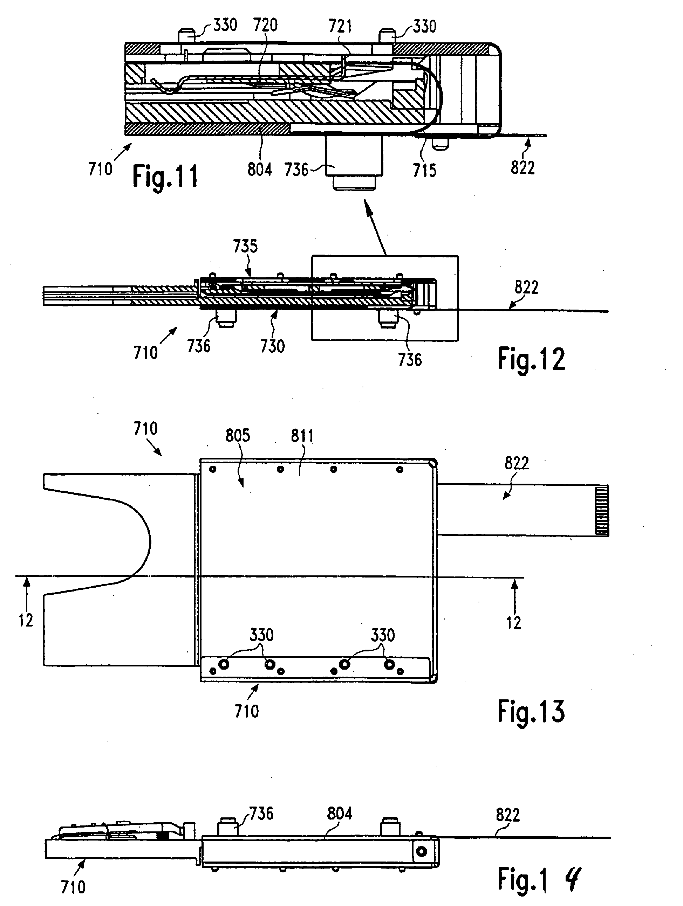

Fig. 11 eine Einzelheit der Fig. 12;
Fig. 12 einen Schnitt in etwa längs Linie 12-12 in Fig. 13;

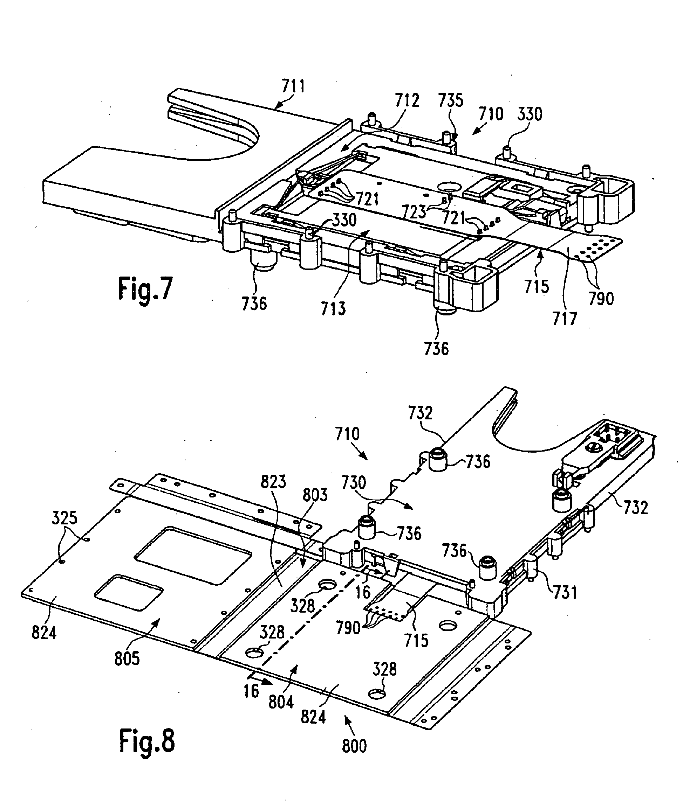

Fig. 13 eine Draufsicht, die Oberseite des eingehüllten Smart Card Readers der Fig. 7;
Fig. 14 eine Seitenansicht der Fig. 13

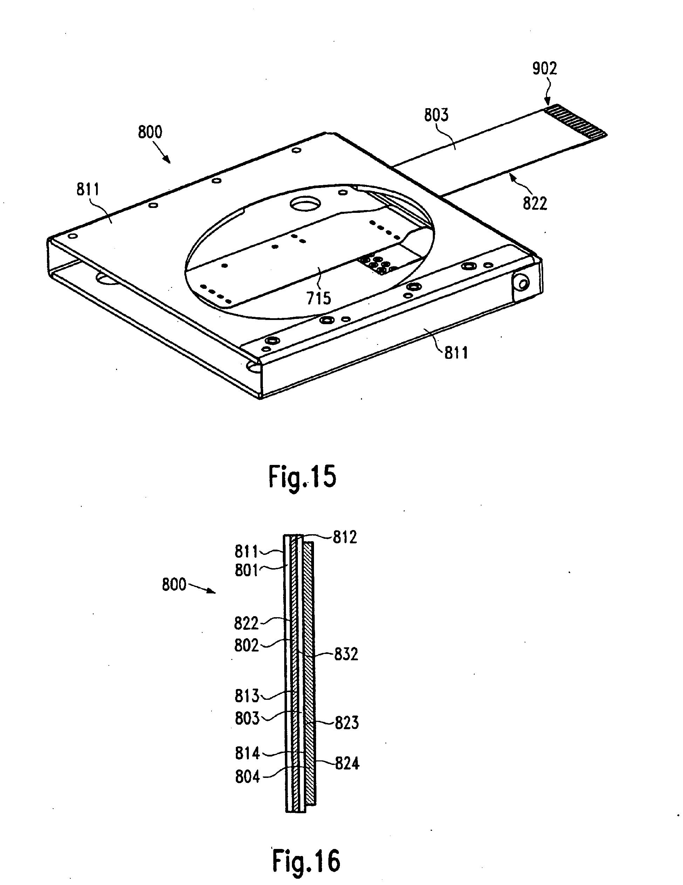

Fig. 15 eine Veranschaulichung, die des Hüll-Flexprints in seiner Hüllposition unter Weglassung des Smart Card Readers, wobei aber dessen üblicher Anschlussflexprint gezeigt ist, zusammen mit dessen Anschlusspunkten für die Verbindung mit dem Hüllflexprint;
Fig. 16 ein Schnitt durch den Hüllflexprint, wobei drei Flexprintlagen und eine Verstärkungslage zu sehen sind;

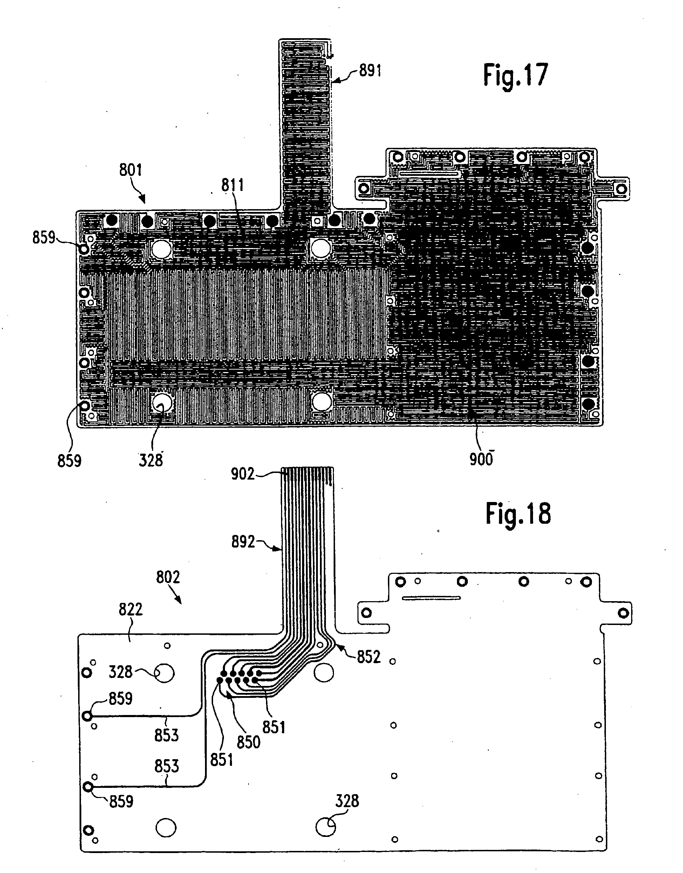

Fig. 17 eine in der Fig. 16 gezeigten Flexprintlagen, die als Schutzflexprintlage bezeichnet wird, wobei hier eine Draufsicht auf die Oberseite dieser Lage dargestellt ist;
Fig. 18 eine Draufsicht auf eine weitere Flexprintlage der Fig. 16, wobei die diese Flexprintlage als Leiterbahnlage bezeichnet wird;
Fig. 19 ein weiteres Ausführungsbeispiel der Erfindung und zwar eine perspektivische Ansicht einer manipulationsgesicherten Kartenleseeinrichtung;
Fig. 20 die Magnetkartenleseeinrichtung gemäß Fig. 19, wobei man auf den Magnetkopf blickt;
Fig. 21 eine perspektivische Draufsicht auf die Anschlussseite des Magnetkopfes;
Fig. 22 eine perspektivische Draufsicht auf einen Datentransferflexprint, der an der in Fig. 21 gezeigten Unterseite des Magnetkopfes 501 angeordnet ist;

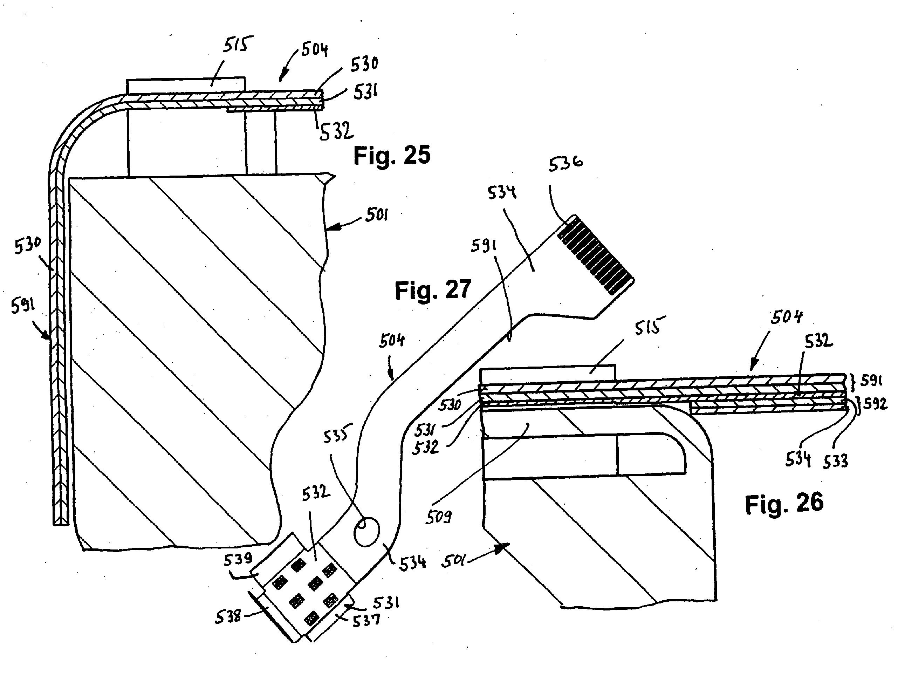

Fig. 23 eine Einzelheit der noch zu erwähnenden Fig. 27;
Fig. 24 einen Schnitt längs der Linie AA in Fig. 22;
Fig. 25 eine Vergrößerung des in Fig. 24 links markierten Bereichs;
Fig. 26 eine Vergrößerung des in Fig. 24 rechts markierten Farbbereichs;
Fig. 27 eine perspektivische Ansicht eines Datentransferflexprint bereit zur Aufnahme des Lesekopfes gemäß Fig. 21.

Der in Fig. 1 gezeigte dreilagige Flexprint 1 (im folgenden "Detektionsflexprint" genannt) bildet, wie in Fig. 2 schematisch gezeigt, einen geschützten Anschluss eines Smart Card Readers 710.

Der dreilagige Detektionsflexprint 1 ist, wie gezeigt, aus den folgenden drei miteinander verklebten oder in anderer Weise integral ausgebildeten Lagen oder Schichten aufgebaut: eine erste oder obere, ein erstes Schutzgitter enthaltende Schutzlage (im Folgenden: oberer "Schutzgitterflexprint") 16, eine zweite oder untere Schutzlage (im Folgenden "unterer Schutzgitterflexprint") 17, und eine mittlere Anschlusslage (im Folgenden "Datentransferflexprint") 15. Der Datentransferflexprint 15 wird auch als Datentransferlage bezeichnet.

Der Datentransferflexprint 15 enthält - wie üblich - die für den Anschluss der Kontaktelemente des Smart Card Readers 710 erforderlichen Leiter oder Leiterbahnen 30 bis 37, die zu Kontaktflächen 20, 21, 22, 23, 24, 25, 26, 27 führen, die zum Anschluss des Smart Card Readers 710 dienen. Die Leiter 20 bis 27 stehen ferner mit am freien Ende des Datentransferflexprint 15 vorgesehenen Kontaktflächen 5 bis 12 in Verbindung um über diese mit einem Gerät, in dem der Smart Card Reader 710 zu verwenden ist, verbunden zu werden.

Zusätzlich sind in dem Datentransferflexprint 15 auch noch, vorzugsweise ausgerichtet mit den Kontaktflächen 5 bis 12 und beidseitig dazu Kontaktflächen oder -zonen 1, 2 und 13, 14 vorgesehen, die mit noch zu beschreibenden Schutzelementen, insbesondere einem Schutzgitter 80 des oberen Schutzgitterflexprints 16 sowie einem Schutzgitter 81 des unteren Schutzgitterflexprints 17 verbunden sind.

In Fig. 2 sieht man ferner, dass beabstandet gegenüber den Kontaktflächen 20 bis 23 und 24 bis 27 weitere Kontaktflächen 28, 29 vorgesehen sind, die über die Kontaktzonen 3, 4 herausgeführt sind. Diese Kontaktflächen 28, 29 können beispielsweise zum Anschluss eines in dem Smart Card Connector 710 vorhandenen Kartenanwesenheitsschalters dienen.

Der in Fig. 3 gezeigte Schutzgitterflexprint 16 weist das Schutzgitter 81 auf, dessen einzelne Leiterbahnen 40 vorzugsweise zickzackförmig über die Breite des Schutzgitterflexprints 16 hin verlaufen.

Diese verschiedenen Leiterbahnen 40 sind vorzugsweise mit einer der Kontaktflächen 1, 2, 13, 14 verbunden, wenn der Schutzgitterflexprint 16 mit seiner Unterseite auf der in Fig. 2 gezeigten Oberseite des Anschlussflexprints 15 platziert ist.

Ferner ist zum Erhalt des erfindungsgemäßen dreilagigen Flexprints 1 der untere Schutzgitterflexprint 17 mit seiner in Fig. 4 gezeigten Oberseite auf der Unterseite des Datentransferflexprint 15 angebracht. Die in dem Schutzgitterflexprint 17 vorgesehenen, das Schutzgitter bildenden Leiterbahnen 41, sind seitlich ähnlich wie bei der Schutzlage 16 herausgeführt, und mit entsprechenden Kontaktflächen 1 oder 2 oder 13 oder 14 verbunden sind.

Bei dem erfindungsgemäßen dreilagigen Detektionsflexprint 1 wird somit der Datentransferflexprint 15 als Datentransferlage benutzt, während die

Schutzgitterflexprints 16 und 17 anschlussmäßig über den Datentransferflexprint 15 herausgeführt oder angeschlossen sind.

Der gemäß der Erfindung vorgesehene Bohrschutz wird somit über zwei parallele, hinsichtlich des Potentials getrennte Leitungen realisiert. Dabei sind die Leiterbahnen oder die Leitungen 40, 41 in den Schutzgitterflexprints 16 und 17 mit einer Breite von 0,2 mm und einem Abstand von 0,2 mm zueinander verlegt. Die Leitungen 40 und 41 bilden jeweils eine durchgehende Schleife, die sich vorzugsweise über die obere Lage 16 und die untere Lage 17 erstreckt. Dabei liegt immer eine Leiterschleife zwischen der anderen, potential mäßig getrennten Leiterschleife.

Wenn versucht wird, die äußeren Schutzgitterflexprint 16 oder 17 mit einem Bohrer zu durchdringen, so wird entweder ein Kurzschluss zwischen den beiden Leiterbahnen 40, 41 erzeugt, was in Fig. 5 für die Leiter 40 dargestellt ist, und/oder eine der Leiterbahnen 40 wird durchtrennt, wobei letzteres in Fig. 6 auch für einen Leiter 40 dargestellt ist.

Die in Fig. 5 und 6 dargestellten Zustände können durch eine entsprechende Elektronik detektiert werden, die an einem oder mehreren der Anschlüsse der Kontaktzonen 1, 2, 13, 14 angeschlossen ist bzw. sind.

Durch die erfindungsgemäßen Maßnahmen wird ein Schutz gegenüber Manipulationen in einfacher Weise erreicht.

Bei dem anhand der Figuren 1 bis 6 beschriebenen Ausführungsbeispiel der Erfindung wurde ein Schutzgitter nur auf dem den Anschluss für den Smart Card Reader bildenden üblichen Flexprint (üblicher Anschlussflexprint), und zwar auf dessen Ober- und Unterseite, angebracht. In diesem Zusammenhang wurde der "übliche Flexprint", d.h. ein Flexprint ohne Manipulationsschutz erwähnt. Nachdem die Schutzgitter ihrerseits in der Form von Flexprints ausgebildet wurden, ergab sich der in Fig. 1 gezeigte dreilagige Detektionsflexprint 1.

In der Beschreibungseinleitung ist auch die Möglichkeit erwähnt, das Schutzgitter direkt auf dem Smart Card Reader an einer oder mehreren geeigneten Stellen aufzubringen. Diese Möglichkeit ist insofern vorteilhaft, als die das bzw. die Schutzgitter bildenden Leiterbahnen platzsparend direkt auf dem Gehäuse des Smart Card Readers angebracht werden können.

Zusätzlich kann auch ein weitreichender Manipulationsschutz für den Smart Card Reader und dessen Anschluss, insbesondere dessen üblichen Datentransferflexprint 15, dadurch erreicht werden, dass man einen Manipulationsdetektionsflexprint vorsieht, der sowohl den, vorzugsweise als üblichen Anschlussflexprint ausgebildeten Anschluss des Smart Card Reader, als auch den Smart Card Reader selbst besser, als dies beim Ausführungsbeispiel gemäß den Figuren 1 bis 4 der Fall ist, schützt.

Dieses Ausführungsbeispiel der Erfindung wird anhand der Figuren 7 bis 18 erläutert. Fig. 7 zeigt in perspektivischer Draufsicht den bekannten, in Fig. 1 nur angedeuteten Smart Card Reader oder Smart Card Connector 710, der ein Gehäuse 711 aufweist, welches beispielsweise, wie gezeigt, oben offen ist. In das Gehäuse 711 ist ein Kontaktträgerrahmen 712 eingesetzt. Im Kontaktträgerrahmen 712 ist ein durch eine (nicht gezeigte) einzusetzende Karte beweglicher Kartenschlitten 713 hin und her bewegbar angeordnet. Eine bügelartige Feder spannt den Kartenschlitten 713 die in Fig. 7 gezeigte Stellung vor. vor. Wenn eine Karte eingesetzt wird, so wird der Kartenschlitten 713 in Fig. 7 nach rechts verschoben, um eine Kontaktierung der Karte vorzusehen.

In dem Kartenschlitten 713 sind die in Fig. 11 zu sehenden Kontaktelemente 720 befestigt, von denen man in Fig. 7 zwei beabstandete Reihen von Anschlussenden 721 erkennt. Ferner sind Anschlussenden 723 in Fig. 7 zu sehen, die zum Anschluss der Kontaktelemente eines Kartenanwesenheitsschalters dienen. Der Anschuss des Smart Card Connectors 710 wird durch einen üblichen Flexprint 715 (auch als Kontaktanschlussfolie oder flexible Leiterplatte zum Anschluss der Kontaktelemente bezeichnet) gebildet. Bei dem Flexprint 715 handelt es sich um den im Zusammenhang mit den Figuren 1 bis 4 beschriebenen "üblichen" (in Fig. 1 mit "1" bezeichneten) Flexprint, d.h. einen Flexprint ohne Manipulationsschutz. Der Flexprint 715 besitzt eine Anschlusszunge 717 mit vorzugsweise ringförmigen (Anschluss-) Kontaktzonen 790.

Erfindungsgemäß wird nun bei diesem Ausführungsbeispiel ein erweiterter Manipulationsschutz nicht nur für den "üblichen" Flexprint 715 sondern auch für den Smart Card Reader 710 insgesamt dadurch erhalten, dass man einen erfindungsgemäßen Detektions- und Anschlussflexprint d.h. eine Detektions-und Anschlussfolie 800 vorsieht. Zur Unterscheidung gegenüber dem dreilagigen Detektionsflexprint 1 gemäß Fig. 1 sei der Detektions- und Anschlussflexprint gemäß diesem Ausführungsbeispiel auch als Hüll-Detektions- und Anschlussflexprint oder kurz als Hüllflexprint 800 bezeichnet.

Die Figuren 8 sowie 15 bis 18 zeigen den Hüllflexprint 800 im Einzelnen. Der Hüllflexprint 800 besteht vorzugsweise aus einer Reader-Schutzlage, vorzugsweise einem (insbesondere den Smart Card Reader schützenden) Readerschutzflexprint 801, einer Verbindungslage, vorzugsweise einem, die notwendigen elektrischen Verbindungen vorsehenden Verbindungsflexprint 802 und einer Anschlussschutzlage, vorzugsweise einem Anschlussschutzflexprint 803. Durch den Readerschutzflexprint 801, den Verbindungsflexprint 802 und den Anschlussschutzflexprint 803 wird der eigentliche eigentliche Hüllflexprint 800 gebildet. Der Hüllflexprint 800 besitzt eine durch den Readerschutzflexprint 801, dem Verbindungsflexprint 802 und dem Datentransferflexprint 803 gebildete Hüllflexprintanschlusszunge 888, die manipulationssicher ausgebildet ist und wie z.B. in den Figuren 8, 9 und 13 gezeigt, aus dem Smart Card Reader 710 herausragt. Vorzugsweise weist der Hüllflexprint 800 noch eine Versteifungslage, vorzugsweise in der Form von zwei Versteifungselementen 804 und 805 auf. Die drei Flexprinte 801 - 803 sind vorzugsweise integral ausgebildet und zwar ebenfalls vorzugsweise zusammen mit den integral damit ausgebildeten Versteifungselementen 804 und 805.

Der Readerschutzflexprint 801 weist eine erste Seite 811 und eine zweite Seite 812 auf. Die erste Seite 811 bildet bezüglich des Smart Card Readers 710 die Außenseite.

Der Verbindungsflexprint 802 weist eine erste Seite 822 und eine zweite Seite 832 auf.

Ferner hat der Anschlussschutzflexprint 803 eine erste Seite 813 und eine zweite Seite 823.

Schließlich besitzen die Versteifungselemente 804, 805 erste Seiten 814 sowie zweite Seiten 824.

In dem Readerschutzflexprint 801 sind ein oder mehrere in geeigneter Weise verbundene und herausgeführte Schutzgitter 900 ausgebildet, und zwar dadurch, dass in dem den Flexprint bildenden Kunststoff Leiterbahnen 950 ähnlich den Leiterbahnen 40 gemäß Fig. 3 ausgebildet sind. Es ist klar, dass zur Erreichung des in den Figuren 5 und 6 veranschaulichten Bohrschutzes die Leiterbahnen 40 in Figur 5 und 6 einen geringen Abstand besitzen müssen. Ferner ist klar, dass die die Schutzgitter 900 bildenden Leiterbahnen 950 in geeigneter Weise über Anschlusskontaktzonen 902 (Fig. 15) herausgeführt werden müssen.

Das bzw. die Schutzgitter 900 sind auch in einer vom Readerschutzflexprint 801 gebildeten Readerschutzflexprintanschlusszunge 891 vorhanden

Auch die im üblichen Anschlussflexprint 715 (Fig. 7) vorhandenen Kontaktelementanschlusszonen 790 müssen vorzugsweise durch bestimmte, im Verbindungsflexprint 802 vorgesehene, über die Anschlusskontaktzonen 902 (Fig. 15) herausgeführt werden.

Die Anschlusskontaktzonen befinden sich vorzugsweise am freien Ende einer Verbindungsflexprintanschlusszunge 892, die schützend vor der Readerschutzflexprintanschlusszunge 891 abgedeckt ist.

Zu diesem Zweck sind in dem Verbindungsflexprint 802 Leiterbahnen 852 vorgesehen, die mit Anschlusspunkten 851 eines Kontaktpunktanschlusssatzes 850 in Verbindung stehen. Leiterbahnen 853 stehen mit dem Schutzgitter 900 in Verbindung und sind auch zu den Anschlusskontaktzonen 902 herausgeführt. Die Anschlusspunkte 851 sind mit den Kontaktelementanschlusszonen bzw. Kontaktpunkten 790 des Flexprints 715 verbunden, vorzugsweise verlötet.

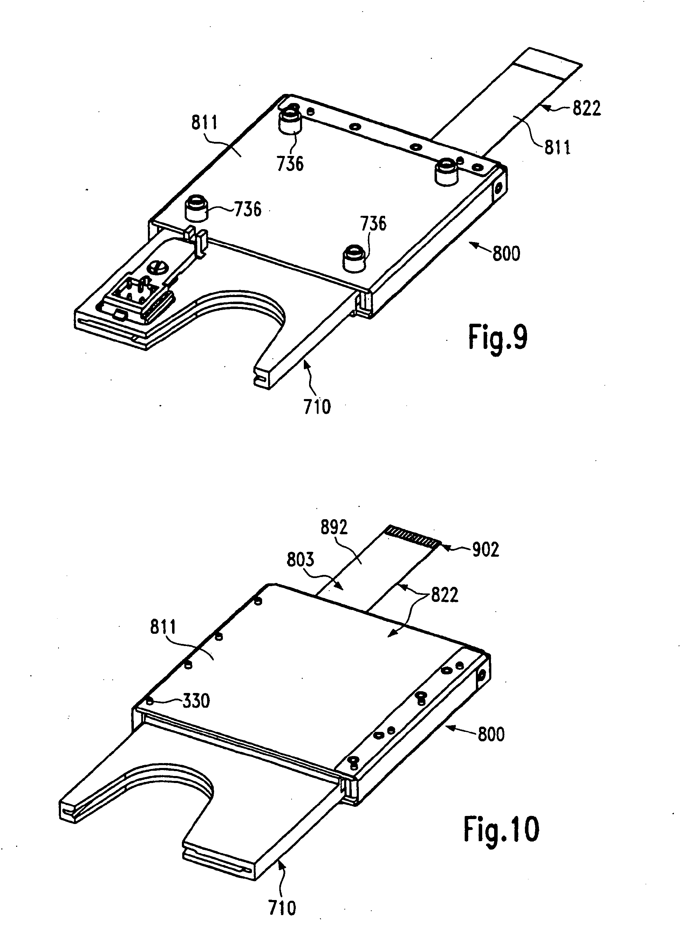

Wie in Fig. 16 gezeigt, weist die Anschlusszunge des Hüllflexprints 800, zusätzlich zu dem durch die Anschlusszunge 891 des Readerschutzflexprints 801 auf der einen Seite erreichten Schutzes auf der anderen Seite der Anschlusszunge 892 des Verbindungsflexprints 802 den schützenden Anschlussschutzflexprint 803 auf und zwar mindestens im Bereich der Anschlusszunge 892 auf. Dieser Anschlussschutzflexprint 803 muss nicht wie der Readerschutzflexprint 801, die gesamte Fläche wie der in Figur 17 gezeigte Readerschutzflexprint 801, durch ein Schutzgitter abdecken, sondern nur mindestens den Bereich der Anschlusszunge 892, was im dargestellten Ausführungsbeispiel durch die in den Figuren 10 und 11 angedeutete Anschlussflexprintzunge 892 geschieht. Die bzw. das im Detektionsflexprint vorhandene Schutzgitter ist vorzugsweise auch über die Anschlusszonen 902 elektrisch überwachbar.

Durch die Verbindungspunkte 859 am Umfang des Readerschutzflexprints 801 und des Anschlussschutzflexprints 803 können die Schutzgitter in den beiden Schutzflexprints 801 und 803 verbunden sein und werden gemeinsam an bestimmten Kontakten des Kontaktsatzes 902 durch Leiterbahnen 853, 859 herausgeleitet.

Das Verfahren zur Anbringung des Hüllflexprints 800 geht wie folgt vor sich:
Als erstes wird der Hüllflexprint 800 wie in Fig. 8 angeordnet, sodass die Anschlusszunge 717 des Flexprints 715 mit ihren Kontaktpunkten 790 zur Auflage auf den Kontaktpunktsatz 850 kommt und mit diesem verlötet wird. Sodann wird der Hüllflexprint 800 aus der in Fig. 8 gezeigten Lage heraus mit den Verstärkungs- bzw. Versteifungselementen 804, 805 um 180° geschwenkt, so dass das eine Verstärkungselement 804 auf der Unterseite 730 des Smart Card Readers 710 zu liegen kommt. Dabei kommen die Befestigungspfosten 736, die einstückig an der Unterseite 730 des Gehäuses 711 des Smart Card Readers 710 ausgebildet sind in entsprechende Löcher 328 im Hüllflexprint 800 in Eingriff. Sodann wird der Hüllflexprint 800 mit der das andere Verstärkungselement 805 tragenden Seite auf die Oberseite 735 des Smart Card Readers 710 umgelegt, wobei Befestigungslöcher 325 im Hüllflexprint 800 mit am Gehäuse 711 des Smart Card Readers 710 vorgesehenen Stiften 330 in Eingriff kommen. Schließlich werden die verbliebenen Seitenteile des Hüllflexprints 800 umgefaltet um die in den Figuren 13, 14 veranschaulichte Gestalt zu erreichen. Die entsprechenden Faltteile werden in entsprechender Weise befestigt.

In Fig. 9 der obigen Beschreibung ist auf dem Smart Card Reader zusätzlich noch eine nicht näher bezeichnete Magnetkartenleseeinrichtung befestigt. Eine solche Magnetkartenleseeinrichtung dient wie der Name sagt zum Lesen von in einer Magnetspur einer Karte gespeicherter Information. Die in Fig. 9 gezeigte Magnetkartenleseeinrichtung ist gegenüber Manipulationen nicht geschützt.

Anhand der Fig. 19 bis 27 wird ein Ausführungsbeispiel der Erfindung beschrieben, welches sich insbesondere auf den Schutz einer Magnetkartenleseeinrichtung 500 bezieht, die ähnlich wie in Fig. 9 gezeigt, auf einem Kartenleser angeordnet sein kann.

Die erfindungsgemäße Magnetkartenleseeinrichtung 500 ist durch die im Folgenden zu beschreibenden Maßnahmen gegenüber Manipulation weitgehend geschützt. Zum Erhalt der erwünschten Manipulationssicherheit greift die im Zusammenhang mit der Magnetkartenleseeinrichtung 500 beschriebene Manipulationssicherung auf die Prinzipien gemäß den vorherigen Ausführungsbeispielen zurück, und zwar insbesondere auch auf die Ausbildung von Schutzlagen bzw. eines Schutzgitterflexprints, wie sie in Fig. 3 und 4 beschrieben wurden und in ihrer Wirkungsweise anhand der Fig. 5 und 6 erläutert wurden. Für all diese Schutzlagen oder Schutzflexprints, beispielsweise auch den Readerschutzflexprint 801 gemäß Fig. 17 wie auch den Anschlussschlutzflexprint 803, werden die, wie in den Fig. 5 und 6 funktionsmäßig veranschaulichten, Gitter verwendet bei deren Kontaktierung oder Durchtrennen durch einen Bohrer nach außen hin durch ein geeignetes Signal Meldung gemacht wird.

Fig. 19 zeigt die erfindungsgemäße Magnetkartenleseeinrichtung 500 hinsichtlich der auf Fig. 9 bezogenen Montagerichtung von unten, während die Fig. 23 ebenfalls perspektivisch die Magnetkartenleseeinrichtung 500 sozusagen von oben zeigt.

Die Magnetkartenleseeinrichtung 500 weist einen Magnetkopf 501 - vergleiche auch Fig. 21 - auf, von dem man in Fig. 19 im Wesentlichen nur eine deutliche in Fig. 24 gezeigte Gleitfläche sieht. Die Magnetkartenleseeinrichtung 500 weist ferner einen Magnetkopfhalter 502 auf, sowie einen Detektionsflexprint 504.

Der Magnetkopf 501 besitzt ein im Allgemeinen aus Kunststoff geformtes Magnetkopfgehäuse 503, in dessen in Fig. 23 gezeigter Oberseite Lesespalte 506 zur Kooperation mit einem Magnetstreifen einer Karte angeordnet ist.

Das Magnetkopfgehäuse 503 bildet an seiner in Fig. 21 gezeigten Unterseite vorzugsweise in allen vier Ecken Anschlussbeine 515. An der in Fig. 21 rechten Seitenkante, d.h. an der Kante, wo der Detektionsflexprint 504 im montierten Zustand herausgeführt wird, sind ferner zwischen den zwei zugehörigen Anschlussbeinen 508 Füllelemente 510, 511 durch das Magnetkopfgehäuse 503 ausgebildet, die ebenfalls zur Manipulationssicherheit beitragen. Zwischen den beiden Füllelementen 510, 511 ist ein Massekontakt 509 vorgesehen. Ferner sind umgebogene Anschlussbeine 508 vorgesehen, die ebenso wie die Füllelemente 510, 511 im montierten Zustand, vergleiche dazu zum Beispiel Fig. 24, auf dem Detektionsflexprint 504 zu liegen kommen. Die Eckfüße oder Abstandshalter 515 ragen vorzugsweise höher über die Unterseite des Magnetkopfgehäuses 503 hinauf als dies die Auflageflächen der Anschlussbeine 508 und der Füllelemente 510, 511 tun.

Der Magnetkopf 501 wird unter Zwischenlage eines Magnetkopfanschlussendes 540 (vergleiche Fig. 22) in geeigneter Weise am Magnetkopfhalter 502 befestigt, wobei insbesondere die Anschlussbeine 508 und der Massekontakt durch einen leitfähigen Kleber an entsprechenden Anschlusszonen des noch näher zu beschreibenden Detektionsflexprints 504 befestigt sind.

Nachdem der Magnetkopf 501 auf dem Magnetkopfhalter 502 befestigt ist, wird dieser mit der Auflagefläche 522 auf die entsprechende am Kartenleser vorgesehene Fläche aufgesetzt und mittels einer durch das Montageloch 520 hindurchgeschraubten Schraube am Kartenleser befestigt. Der Magnetkopfhalter 502 weist noch in Fig. 23 gezeigt eine Druckfederaufnahme 521 sowie einen Positionierungszapfen 523 auf.

Der Detektionsflexprint 504 ist im Prinzip ähnlich aufgebaut, wie der in Fig. 1 gezeigte, dort als Detektionsflexprint 1 bezeichnete Flexprint. Beim Ausführungsbeispiel gemäß den Fig. 1 bis 3 sieht der Detektionsflexprint 1 Manipulationsschutz zum einen bei der in Fig. 1 bis 3 nicht näher bezeichneten Anschlusszunge vor, zum anderen aber auch im Bereich des in den Smart Card Reader 10 hineinragenden Teils des Detektionsflexprints 1.

Bei dem in den Fig. 7 bis 16 beschriebenen Ausführungsbeispielen ist ein Hüllflexprint 800 erläutert, der den Smart Card Reader 710 dadurch gegen Manipulation schützt, dass der Hüllflexprint den Smart Card Reader 17 manipulationssicher umhüllt, so dass der Smart Card Reader 710 allseitig geschützt ist. Die Hüllflexprintanschlusszunge ist dabei ähnlich in den Fig. 1 bis 4 unten und oben durch entsprechende mit den erfindungsgemäßen aus Leitern aufgebauten Schutzgittern in Readerschutzflexprint 801 und im Anschlussschutzflexprint 803 geschützt.

Ein Ende eines Detektionsflexprints 504 besteht ähnlich wie bei beiden zuvor beschriebenen Ausführungsbeispielen - vergleiche dazu Fig. 22 - aus einem Magnetkopfanschlussende 540 und einer Magnetkopfanschlusszunge 542.

Ähnlich wie beim Ausführungsbeispiel gemäß den Fig. 7 bis 16 sieht das Magnetkopfanschlussende 540 sowohl Mittel zum Anschluss an die Anschlussbeine 508 sowie den Massekontakt 509 des Magnetkopfs 501 vor, darüber hinaus ist das Magnetkopfanschlussende 540 aber noch so ausgebildet, dass es den Magnetkopf 501 ähnlich wie der Hüllflexprint 800 den Smart Card Reader 710 hier im Lesekopf 501 an solchen gefährdeten Stellen umhüllt.

Dies soll jetzt im Einzelnen insbesondere unter Bezugnahme auf die Fig. 24 bis 27 erläutert werden.

Fig. 27 zeigt eine perspektivische Ansicht des Detekionsflexprints 504, bevor der Lesekopf 501 wie in Fig. 23 gezeigt auf das Magnetkopfanschlussende 540 aufgesetzt und zusammen mit dem Lesekopf 501 in den Magnetkopfhalter 502 eingesetzt und befestigt ist.

In Fig. 24 sowie den zugehörigen Abschnittsvergrößerungen gemäß den Fig. 25 und 26 erkennt man, dass der Detektionsflexprint 504 aus mehreren Lagen oder Schichten, die miteinander verbunden sind, aufgebaut ist. Im dargestellten Ausführungsbeispiel weist der Detektionsflexprint 504 folgende fünf Schichten auf: eine erste Schutzschicht 530, eine zweite Schutzschicht 531, eine dritte Schicht 532, die auch als Verbindungslage bzw. Verbindungsflexprint 532 bezeichnet wird, und eine vierte Schutzschicht 533 sowie eine fünfte Schutzschicht 534.

Die erste Schutzschicht 530 und die zweite Schutzschicht 531 bilden eine Magnetkopfschutzschicht, insbesondere einen Magnetkopfschutzflexprint. Der Begriff Magnetkopfschutzflexprint 591 soll besagen, dass der Magnetkopfschutzflexprint insbesondere auch Schutz für den Magnetkopf 501 vorsieht. Wie man in Fig. 25 erkennen kann, ist der Magnetkopfschutzflexprint um die Seitenflächen des Magnetkopfes 501 herumgeführt und daran angeklebt und sieht so einen Manipulationsschutz vor. Der Magnetkopfschutzflexprint 591 sieht aber auch auf seiner anderen Seite im Bereich der Magnetkopfanschlusszunge 542 Manipulierschutz vor.

Der Magnetkopfschutzflexprint 591 ist anders als das entsprechende Bauteil im ersten Ausführungsbeispiel und auch im zweiten Ausführungsbeispiel zweischichtig oder zweilagig aufgebaut. Dadurch kann man das erforderliche Schutzgitter zur Erreichung der in den Fig. 5 und 6 dargestellten Wirkung in der einen Schicht aufbauen, während man in der zugehörigen zweiten Schicht die erforderlichen Verdrahtungen vorsieht und an geeigneter Stelle mit dem Verbindungsflexprint 532 verbindet um dann über die Anschlusskontakte 536 des Verbindungsflexprints 532 die notwendige Information über Manipulationen zu erhalten.

Das gleiche gilt für den zweischichtigen Aufbau des Schutzflexprints 592.

Wie man in Fig. 26 erkennt, endet der fünfschichtige Aufbau des Detektionsflexprints 504 am Massekontakt 509 bzw. an den Füllelementen 510 und 511. Ab diesem Punkt dringt der Magnetkopfschutzflexprint 591 und der Verbindungsflexprint 532 in die Magnetkartenleseeinrichtung 501 ein. Der Verbindungsflexprint 532, der mit seinen entsprechenden Leiterbahnen mit den Anschlussbeinen 508 elektrisch verbunden ist endet wie in Fig. 25 gezeigt, wobei sodann vorzugsweise lediglich der Magnetkopfschutzflexprint 591 um die Seitenflächen des Magnetkopfes 501 herumgeschlagen und daran manipulationssicher befestigt ist. Im Einzelnen sieht man in den Fig. 22 und 25, dass durch die von Flügeln 537, 538 und 539 des Magnetschutzflexprints 591 gebildeten Ecken im Zusammenwirken mit den Eckfüßen 515 eine sichere Halterung für das Magnetkopfanschlussende 540 erreicht wird.

## Patentansprüche

1. Smart Card Reader (710) mit einem Gehäuse (711), in dem zum Kontaktieren einer Smart Card geeignete Kontaktelemente (20) angeordnet sind, **gekennzeichnet durch**:
einen Detektionsflexprint (1), über den die Kontaktelemente (20) elektrisch anschließbar sind, wobei der Detektionsflexprint (1) einen Datentransferflexprint (15, 715) aufweist, auf der mindestens eine Schutzlage (16, 17) vorgesehen ist, die ein Schutzgitter (80, 81) aufweist, und
wobei das Schutzgitter das Gehäuse (711) im Bereich von möglichen Lunerwünschten Manipulationen und den Datentransferflexprint (15,715) umgibt, wobei das Schutzgitter (80, 81) eng angeordnete elektrische Leiter bzw. Leiterbahnen (40) aufweist, deren Durchtrennung und/oder deren Kurzschließen **durch** Änderung der elektrischen Eigenschaft des Schutzgitters (80, 81) von außen her feststellbar ist, wodurch Manipulationsversuche erkennbar sind.

2. Smart Card Reader (710) nach Anspruch 1, **dadurch gekennzeichnet, dass** das Schutzgitter (80 81) in einem das Gehäuse (711) und vorzugsweise auch den Datentransferflexprint (15,715) umhüllenden Hüllflexprint (800) ausgebildet ist.

3. Smart Card Reader (710) nach Anspruch 2, **dadurch gekennzeichnet, dass** das Schutzgitter (80, 81) in einem integralen Hüllflexprint (800) realisiert ist, und zwar bestehend aus einem Readerschutzflexprint (801), einem Verbindungsflexprint (802) und einem Anschlussschutzflexprint (803).

4. Smart Card Reader (710) nach Anspruch 3, wobei der Readerschutzflexprint (801) bei der Umhüllung des Smart Card Readers (710) die äußere Lage bildet.

5. Smart Card Reader (710) nach einem der Ansprüche 2 - 4, wobei der Hüllflexprint (800) im Ganzen eine rechteckige Form besitzt und zwei Hauptabschnitte bildet, von dem einer die Unterseite und der andere die Oberseite des Smart Card Readers abdeckt, und wobei der Hüllflexprint (800) um die Seitenkanten des Smart Card Readers (710) herumfaltbare Abschnitte bildet.

6. Smart Card Reader (710) nach einem der Ansprüche 2-5, wobei der Hüllflexprint zwei Verstärkungselemente (804, 805) aufweist, dessen eines (804) eine Abdeckung für eine Oberseite (735) des Smart Card Readers (710) bildet.

7. Smart Card Reader (710) nach einem der Ansprüche 2-6, wobei eine aus dem Smart Card Reader herausgeführte Anschlusszunge (717) des Datentransferflexprints (715) mit Kontaktpunkten (790) an Kontaktpunkten (851) des Verbindungsflexprints (802) angelötet ist, derart, dass der Readerschutzflexprint (801) den Manipulationsschutz für die Anschlusszunge (717) vorsieht und wobei der Hüllflexprint (800) eine Anschlusszunge (822) bildet, die die elektrische Verbindung des geschützten Smart Card Readers (710) mit einem weiteren Gerät vorsieht.

8. Smart Card Reader (710) nach Anspruch 7, wobei die Anschlusszunge (717) des Smart Card Readers Anschlusskontaktzonen (790) für die herauszuführenden Leiterbahnen besitzt, und wobei eine Anschlusszunge (892) des Verbindungsflexprints (802) auf der einen Seite durch das Gitter des Readerschutzflexprints (801) geschützt ist, während auf der anderen Seite der Schutz durch einen Anschlussschutzflexprint (803) erfolgt, der ebenfalls mit einem Schutzgitter ausgestattet ist, welches vorzugsweise über den Datentransferflexprint mit dem Readerschutzflexprint (801) verbunden ist und wobei die Schutzgitter über die Kontaktzonen des Verbindungsflexprints (802) herausgeführt ist.

9. Smart Card Reader (710) nach einem der Ansprüche 7-8, wobei die Anschlusszunge (717) des Datentransferflexprints (715) an Anschlusspunkte (851) im Verbindungsflexprints angelötet ist.

10. Anschlussflexprint für eine an eine elektrische Schaltung anzuschließende Vorrichtung, insbesondere für einen Smart Card Reader, **gekennzeichnet durch**: mindestens einen zum Anschluss an das Gerät dienenden Datentransferflexprint (715), auf dem mindestens eine Schutzlage (16, 17) vorgesehen ist, die ein Schutzgitter (80, 81) aufweist, wobei in die Schutzlage (16, 17) Leiter oder Leiterbahnen (40, 41) eingebettet sind, die das Schutzgitter (80, 81) bilden derart, dass deren Durchtrennung und/oder deren Kurzschließen aufgrund des Eindringens von Metallteilen, beispielsweise einem Bohrer, **durch** Änderung der elektrischen Eigenschaft des Schutzgitters (80, 81) von außen her feststellbar ist, wodurch Manipulationsversuche erkennbar sind.

11. Flexprint nach Anspruch 10, wobei die als Datentransferflexprint ausgebildete Mittellage (15) auf beiden Seiten mit der Schutzlage (16) bzw. der Schutzlage (17) versehen ist.

12. Flexprint nach der Anspruch 11, **dadurch gekennzeichnet, dass** die Leiterbahnen (40, 41) der Schutzlagen (16, 17) über Kontaktzonen, vorgesehen an der Mittellage (15), herausgeführt sind.

## Claims

1. A Smart Card Reader (710) having a housing (711) within which contact elements (20) are arranged suitable for contacting a smart card **characterized by**:
a detection flex print (1) by means of which said contact elements (20) can be electrically contacted,
said deflection flex print (1) comprising a data transfer flex print (15, 715) on which at least one protective layer (16, 17), said at least one protective layer (16, 17) being provided with a protective grating (80, 81), and, wherein the protective grating surrounds both the housing (711) in the area of possible but
undesirable manipulations and the data flex print (15, 715),
wherein the protective grating (80, 81) comprises closely arranged electrical conductors, respectively; and wherein
the severing and/or the short circuiting of said electrical conductors can be recognized from the outside due to a change of the electrical characteristics of the protective grating (80, 81) such that manipulation can be recognized.

2. The Smart Card Reader (710) of claim 1 **characterized in that** the protective grating (80, 81) is formed in an enveloping flex print (800) adapted to surround the housing (711) and preferably also the data transfer flex print (15, 715).

3. The Smart Card Reader (710) as set forth in claim 2 **characterized in that** the protective grating (80, 81) is realized in an integral enveloping flex print (800), comprising a reader protection flex print (801), a connecting flex print (802), and a termination protection flex print (803).

4. The Smart Card Reader (710) as set forth in claim 3 wherein the reader protective flex print (801) forms, when enveloping the Smart Card Reader (710), the outermost layer.

5. The Smart Card reader (710) as set forth in one of claims 2-4 wherein the enveloping flex print (800) has a generally rectangular shape and forms two main sections with one section covering the lower surface and the other section covering the upper surface of the Smart Card Reader (710), and wherein the enveloping flex print (800) forms sections which can be folded around the side edges of the said Smart Card Reader (710).

6. The Smart Card Reader (710) as set forth in one of claims 2-5 wherein the enveloping flex print (800) comprises two reinforcement elements (804, 805) one enforcement element (804) forming a cover for an upper surface (735) of the Smart Card Reader (710).

7. The Smart Card Reader (710) as set forth in one of claims 2-6 wherein a connection tongue (707) of the data transfer flex print (715) extends out of said Smart Card Reader (710) and is soldered to contact point (790) at contact points (851) of the connecting flex print (802) such, that the reader protective flex print (801) provides the manipulation protection for the connecting tongue (717) and wherein the envelope flex print (800) forms a connection tongue (822) which provides the electrical connection of the protected Smart Card Reader (710) with a further apparatus.

8. The Smart Card Reader (710) as set forth in claim 7 wherein the termination tongue (717) of the Smart Card Reader (710) comprises termination contact zones (790) for the electrical conductors which have to be connected with the outside and wherein a connecting tongue (892) of the connecting flex print (802) is protected on the one side by means of the grating of the reader protective flex print (801) while protection is provided on the other side by a termination flex print (803), which is also provided with a protective grating which preferably is connected by the data transfer flex print with the reader protective flex print (801) and wherein the protective grating is connected with the outside via the contact zones of the connecting flex print (802).

9. The Smart Card Reader (710) as set forth in one of claims 7-8 wherein the connecting tongue (717) of the data transfer flex print (715) is soldered to connecting points (851) in the connecting flex print.

10. A connecting flex print for an apparatus to be connected to an electrical circuit of an apparatus, in particular a Smart Card Reader, **characterized by**:
at least one data transfer flex print (715) adapted for connection with said apparatus,
said data transfer flex print (715) being provided with at least one protective layer (16, 17) which comprises a protective grating (80, 81) wherein into the protective layer (16, 17) conductors or conductive traces (40, 41) are embedded which form the protective grating (80, 81) such, that the severing and/or the short circuiting due to the penetration of metal parts for instance, a drill can be recognized from the outside due to changes of the electrical characteristics of the protective grating (80, 81) such that manipulation attempts can be recognized.

11. A flex print of claim 10 wherein the middle layer (15) formed as a data transfer flex print is provided on both sides with the protective layer (16) and the protective layer (17), respectively.

12. The flex print of claim 11 **characterized in that** the conductors or conductive traces (40, 41) of the protective layer (16, 17) are accessible from the outside by contact zones provided at the middle layer (15).

## Revendications

1. Lecteur de carte à puce (710) comportant un boîtier (711) dans lequel des éléments de contact (20) sont agencés et sont adaptés pour contacter une carte à puce, **caractérisé par** :
un circuit imprimé souple de détection (1) au moyen duquel les éléments de contact (20) peuvent être contactés électriquement,
le circuit imprimé souple de détection (1) comprenant un circuit imprimé souple de transfert de données (15, 715) sur lequel se trouve au moins une couche de protection (16, 17), ladite au moins une couche de protection (16, 17) étant munie d'une grille de protection (80, 81), et la grille de protection entourant à la fois le boîtier (711) dans la zone de manipulation possible mais non souhaitable et le circuit imprimé souple de données (15, 715),
la grille de protection (80, 81) comprenant des conducteurs électriques disposés de façon rapprochée, respectivement ; et dans lequel
une rupture et/ou un court-circuit des conducteurs électriques peuvent être reconnus de l'extérieur en raison d'un changement des caractéristiques électriques de la grille de protection (80, 81) de sorte qu'une manipulation peut être reconnue.

2. Lecteur de carte à puce (710) selon la revendication 1, **caractérisé en ce que** la grille de protection (80, 81) est formée dans un circuit imprimé souple enveloppant (800) adapté pour entourer le boîtier (711) et aussi de préférence le circuit imprimé souple de transfert de données (15, 715).

3. Lecteur de carte à puce (710) selon la revendication 2, **caractérisé en ce que** la grille de protection (80, 81) est réalisée dans un circuit imprimé souple enveloppant (800) d'une seule pièce, comprenant un circuit imprimé souple de protection de lecteur (801), un circuit imprimé souple de connexion (802), et un circuit imprimé souple de protection de terminaison (803).

4. Lecteur de carte à puce (710) selon la revendication 3, dans lequel le circuit imprimé souple de protection (801) forme, lorsqu'il enveloppe le lecteur de carte à puce (710), la couche la plus externe.

5. Lecteur de carte à puce (710) selon l'une quelconque des revendications 2 à 4, dans lequel le circuit imprimé souple enveloppant (800) a une forme générale rectangulaire et forme deux sections principales, une section couvrant la surface inférieure et l'autre section couvrant la surface supérieure du lecteur de carte à puce (710), et le circuit imprimé souple enveloppant (800) formant des sections qui peuvent être repliées autour des bords latéraux du lecteur de carte à puce (710).

6. Lecteur de carte à puce (710) selon l'une quelconque des revendications 2 à 5, dans lequel le circuit imprimé souple enveloppant (800) comprend deux éléments de renfort (804, 805), un des éléments de renfort (804) formant une couverture pour une surface supérieure (735) du lecteur de carte à puce (710).

7. Lecteur de carte à puce (710) selon l'une quelconque des revendications 2 à 6, dans lequel une languette de connexion (707) du circuit imprimé souple de transfert de données (715) s'étend hors du lecteur de carte à puce (710) et est soudée au point de contact (790) en des points de contact (851) du circuit imprimé souple de connexion (802), de sorte que le circuit imprimé souple de protection de lecteur (801) assure une protection contre les manipulations pour la languette de connexion (717), et dans lequel le circuit imprimé souple d'enveloppe (800) forme une languette de connexion (822) qui assure une connexion électrique du lecteur de carte à puce (710) avec un autre appareil.

8. Lecteur de carte à puce (710) selon la revendication 7, dans lequel la languette de terminaison (717) du lecteur de carte à puce (710) comprend des zones de contact de terminaison (790) pour les conducteurs électriques qui doivent être connectés avec l'extérieur, et dans lequel une languette de connexion (892) du circuit imprimé souple de connexion (802) est protégée d'un côté au moyen de la grille du circuit imprimé souple de protection de lecteur (801) tandis qu'une protection est assurée de l'autre côté par un circuit imprimé souple de terminaison (803), qui est aussi muni d'une grille de protection qui est de préférence connectée par le circuit imprimé souple de transfert de données avec le circuit imprimé souple de protection de lecteur (801), et dans lequel la grille de protection est connectée avec l'extérieur par l'intermédiaire des zones de contact du circuit imprimé souple de connexion (802).

9. Lecteur de carte à puce (710) selon l'une quelconque des revendications 7 à 8, dans lequel la languette de connexion (717) du circuit imprimé souple de transfert de données (715) est soudée à des points de connexion (851) dans le circuit imprimé souple de connexion.

10. Circuit imprimé de connexion pour un dispositif à connecter à un circuit électrique d'un dispositif, en particulier un lecteur de carte à puce, **caractérisé par** :
au moins un circuit imprimé souple de transfert de données (715) adapté pour une connexion avec le dispositif,
le circuit imprimé souple de transfert de données (715) étant muni d'au moins une couche de protection (16, 17) qui comprend une grille de protection (80, 81), dans lequel dans la couche de protection (16, 17) des conducteurs ou des pistes conductrices (40, 41) sont intégrés et forment la grille de protection (80, 81), de sorte qu'une rupture et/ou un court-circuit dus à la pénétration de parties métalliques par exemple, ou à une perforation, peuvent être reconnus de l'extérieur en raison de changements dans les caractéristiques électriques de la grille de protection (80, 81) de sorte que des tentatives de manipulation peuvent être reconnues.

11. Circuit imprimé souple selon la revendication 10, dans lequel la couche centrale (15) formée sous forme d'un circuit imprimé souple de transfert de données est munie sur ses deux côtés de la couche de protection (16) et de la couche de protection (17), respectivement.

12. Circuit imprimé souple selon la revendication 11, **caractérisé en ce que** les conducteurs ou les pistes conductrices (40, 41) de la couche de protection (16, 17) sont accessibles de l'extérieur par des zones de contact prévues au niveau de la couche centrale (15).
